# EUROPÄISCHE PATENTSCHRIFT

(11) **EP 1 828 785 B1**
(45) Veröffentlichungstag und Bekanntmachung des Hinweises auf die Patenterteilung: **07.03.2012**
(21) Anmeldenummer: 05807848.6
(22) Anmeldetag: 21.11.2005
(51) Int. Cl.: G01R 1/067

(54) **MESSSPITZE FÜR HF-MESSUNG**
MEASURING TIP FOR MEASURING HIGH FREQUENCY
POINTE DE MESURE POUR MESURE HAUTE FRÉQUENCE

(30) Priorität: 20.12.2004 DE 202004019636 U
(43) Veröffentlichungstag der Anmeldung: 05.09.2007
(73) Patentinhaber: Rosenberger Hochfrequenztechnik GmbH & Co. KG, 83413 Fridolfing (DE)
(72) Erfinder: THIES, Steffen, 83329 Waging (DE); WOLLITZER, Michael, 83413 Fridolfing (DE)
(74) Vertreter: Zeitler, Giselher
(86) Internationale Anmeldenummer: PCT/EP2005/012444
(87) Internationale Veröffentlichungsnummer: WO 2006/066676

(56) Entgegenhaltungen:
- WO-A-01/22097
- US-A- 4 853 627
- US-A- 4 894 612
- US-A- 5 003 253
- US-A- 5 506 515

## Beschreibung

Die vorliegende Erfindung betrifft eine Kontaktanordnung, insbesondere für eine Messsonde oder einen Messkopf, zur Hochfrequenzmessung, insbesondere auf einem Halbleiterwafer, mit einem kontaktseitigen Ende zum elektrischen Kontaktieren von planaren Strukturen, wobei am kontaktseitigen Ende eine koplanare Leiterstruktur mit wenigstens zwei von einem Dielektrikum getragenen Leitern angeordnet ist, wobei zwischen dem Dielektrikum und dem kontaktseitigen Ende die Messspitze derart ausgebildet ist, dass die Leiter der koplanaren Leiterstruktur frei im Raum und bzgl. des halternden Dielektrikums federnd angeordnet sind, gemäß dem Oberbegriff des Anspruchs 1.

Eine gattungsgemäße Kontaktanordnung in Form einer Messspritze ist aus der DE 199 45 178 C2 bzw. WO 01/220987 A1 bekannt. Zum Testen von beispielsweise auf Wafern hergestellten, elektronischen Schaltungen auf deren Funktionsfähigkeit und deren elektrischen Eigenschaften werden üblicherweise derartige Messspitzen verwendet, welche auf entsprechenden Kontaktstellen der zu testenden elektronischen Schaltung mechanisch aufsetzen. Derartige zu testende elektronische Schaltung erzeugen bzw. verarbeiten zunehmend auch Hochfrequenzsignale, so dass sich für die Messspitze eine entsprechend zu beachtende Impedanz ergibt. Mit anderen Worten muss die Messspitze eine an den Kontakt mit der zu testenden elektrischen Schaltung angepasste Impedanz aufweisen, da sich sonst bei Fehlanpassungen, wie allgemein bekannt, entsprechende Reflexionen ergeben, welche ein Messergebnis in unerwünschter Weise beeinflussen oder eine Messung gar unmöglich maschen. Auch über die Messspitze selbst sollte sich keine Änderung der Impedanz ergeben, da auch derartige Impedanzsprünge entsprechende Reflexionsstellen erzeugen.

Dokument JP 2001066324 A beschreibt ein Messspitzen-Adapter, welches eine kleine, unmontierte Leiterplatte enthält und mit einem BNC-Stecker verbindbar ist. Durch die Montage wird ein elektrischer Schaltkreis hergestellt. Diese Anordnung ist jedoch aufwändig in Herstellung und Montage. Darüber hinaus sind keine Vorkehrungen für eine kontrollierte Impedanz getroffen.

Aus US 4 894 612 ist eine Messspitze mit einer Koplanarleitung und einer integrierten Schaltung bekannt, wobei die integrierte Schaltung auf einem Substrat angeordnet ist. Die Schaltung ist mit der Koplanarleitung verbunden. Zusätzliche Streifenleitungen stellen eine elektrische Verbindung von einer externen Schaltung zur der Schaltung zur Verfügung.

Druckschrift US 4 853 627 betrifft eine Wafermessspitze, wobei an einer Spitze ein Verstärker angeordnet ist. Die Messspitze, welche ein zu prüfendes Objekt elektrisch kontaktiert, ist als ein Teil des Verstärkers ausgebildet. Mikrostreifenleitungen verbinden den Verstärker mit Anschlüssen, wie beispielsweise einem Koaxialverbinder.

Druckschrift US 5 003 253 betrifft eine aktive Mikrowellen-Messspitze mit einem Substrat, auf dem eine Koplanarleitung angeordnet ist. Die Koplanarleitung ist mit koaxialen Anschlüssen verbunden. Es ist jedoch zwischen der Koplanarleitung und den koaxialen Anschlüssen keine zusätzliche, Signal übertragende Schaltung vorgesehen.

Der Erfindung liegt die Aufgabe zugrunde, eine Kontaktanordnung der o.g. Art bzgl. der Signalübertragung und der möglichen Anwendungsgebiete zu verbessern bzw. zu erweitern.

Diese Aufgabe wird erfindungsgemäß durch eine Kontaktanordnung der o.g. Art mit den in Anspruch 1 gekennzeichneten Merkmalen gelöst. Vorteilhafte Ausgestaltungen der Erfindung sind in den weiteren Ansprüchen beschrieben.

Bei einer Kontaktanordnung der o.g. Art ist es erfindungsgemäß vorgesehen, dass auf dem Dielektrikum wenigstens eine Anordnung zum Übertragen von elektrischen Signalen angeordnet ist, die elektrisch mit wenigstens einem Leiter der koplanaren Leiterstruktur derart verbunden ist, dass diese Anordnung Signale von dem wenigstens einen mit der Anordnung elektrisch verbundenen Leiter überträgt, wobei die Kontaktanordnung ein koaxialkabelseitiges Ende mit einer koaxialen Leiterstruktur aufweist, wobei die Anordnung zum Übertragen von elektrischen Signalen mit wenigstens einem Koaxialkabelanschluss der koaxialen Leiterstruktur derart verbunden ist, dass die Anordnung Signale zwischen dem wenigstens einen mit der Anordnung elektrisch verbundenen Leiter und dem wenigstens einen mit der Anordnung elektrisch verbundenen Koaxialkabelanschluss der koaxialen Leiterstruktur überträgt, wobei sich das Dielektrikum bis zum koaxialkabelseitigen Ende erstreckt.

Dies hat den Vorteil, dass mehrere HF-Signal bzw. HF-Kanäle aufgenommen und zu dem/den Kontakt(en) übertragen werden können, wobei eine störungsfreie und möglichst verlustfreie Signalübertragung durch die Anordnung zusätzlich unterstützt wird. Gleichzeitig ergibt sich eine kleine bzw. bauraumsparende Bauweise. Die Anordnung ermöglicht zusätzlich die Anpassung der Kontaktanordnung an unterschiedlichste Messaufgaben, so dass der Anwendungsbereich der Kontaktanordnung auf Messspitzen und Nadelkarten erweitert ist. Eine einheitliche Halterung in Form einer Grundplatte von den Leitern der koplanaren Leiterstruktur, der Anordnung zum Übertragen von elektrischen Signalen und der HF- sowie ggf. DC-Kontakte am koaxialkabelseitigen Ende erzielt man dadurch, dass sich das Dielektrikum bis zum koaxialkabelseitigen Ende erstreckt.

In einer bevorzugten Ausführungsform ist auf dem Dielektrikum wenigstens ein Kontakt zum Abgreifen des elektrischen Signals angeordnet, wobei die Anordnung zum Übertragen von elektrischen Signalen derart angeordnet und ausgebildet ist, dass die Anordnung das elektrische Signal von dem von dem wenigstens einen mit der Anordnung elektrisch verbundenen Leiter zum Kontakt überträgt.

Beispielsweise ist die Anordnung zum Übertragen von elektrischen Signalen eine elektronische Schaltung.

Zweckmäßigerweise sind am koaxialkabelseitigen Ende zwei oder mehr Koaxialkabelanschlüsse zum Verbinden mit einem jeweiligen Koaxialkabel angeordnet und mit der Anordnung zum Übertragen von elektrischen Signalen elektrisch verbunden.

In einer bevorzugten Ausführungsform umfasst die Anordnung zum Übertragen von elektrischen Signalen eine Umverdrahtung, ein Anpassnetzwerk und/oder eine aktive Schaltung.

Zum Übertragen von beispielsweise Versorgungsspannungen und/oder Steuersignalen ist am Dielektrikum wenigstens ein Gleichstromkontakt vorgesehen und mit der Anordnung zum Übertragen von elektrischen Signalen elektrisch verbunden ist.

In einer bevorzugten Ausführungsform ist am Dielektrikum eine Halterung für einen Manipulator angeordnet.

Beispielsweise sind die Leiter der koplanaren Leiterstruktur über Löt- und/oder Punktschweißverbindungen mit jeweiligen Leiterbahnen der Anordnung zum Übertragen von elektrischen Signalen elektrisch verbunden.

Zum Gewährleisten eines konstanten Wellenwiderstandes über die Anordnung ist zwischen je zwei Leitern der koplanaren Leiterstruktur über deren gesamte Länge ein jeweiliger Spalt derart ausgebildet, dass sich über die Länge der koplanaren Leitungsstruktur ein konstanter Wellenwiderstand ergibt, wobei insbesondere der jeweilige Spalt im Bereich des Dielektrikums breiter als in Bereich der koplanaren Leiterstruktur ohne Dielektrikum ausgebildet ist.

Zum Unterdrücken von Moden höherer Ordnung oberhalb der gewünschten Betriebsfrequenz ist das Dielektrikum an einer der koplanaren Leiterstruktur abgewandten Seite vollflächig metallisiert. Ferner ergibt sich dadurch im Bereich des Dielektrikums eine geschlossene, abgeschirmte Struktur.

Beispielsweise ist das Dielektrikum wenigstens einseitig, insbesondere beidseitig an der koplanaren Leiterstruktur angeordnet.

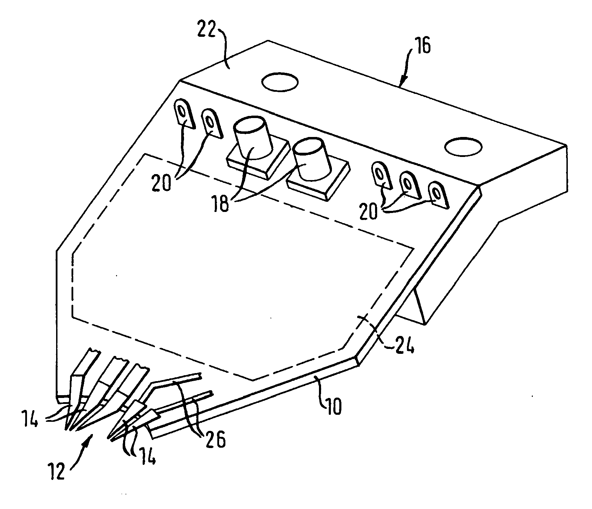

Die Erfindung wird im Folgenden anhand der Zeichnung näher erläutert. Diese zeigt in der einzigen Figur eine bevorzugte Ausführungsform einer erfindungsgemäßen Anordnung zum Übertragen von elektrischen Signalen in perspektivischer Darstellung.

Die aus der einzigen Figur ersichtliche, bevorzugte Ausführungsform einer erfindungsgemäßen Anordnung zum Übertragen von elektrischen Signalen in Form eines Nadelkamms für die Messung von Hochfrequenz-Halbleiterschaltungen beispielsweise auf Halbleiterwafern umfasst ein Dielektrikum 10, eine koplanare Leiterstruktur an einem kontaktseitigen Ende 12 der Messespitze mit mehreren Leitern 14 und zwei Koaxialkabelanschlüsse 18 an einem koaxialkabelseitigen Ende 16 der Messespitze, welche zum Verbinden mit einem jeweiligen, nicht dargestellten Koaxialkabel ausgebildet sind, sowie mehrere Gleichstromkontakte 20. Die koplanare Leiterstruktur ist an dem Dielektrikum 10 derart angeordnet, dass sich über die gesamte Länge der koplanaren Leiterstruktur eine kontrollierte, vorbestimmte Impedanz ergibt. Hierzu ist insbesondere der seitliche Abstand zwischen den Leitern 14 entsprechend gewählt. Zwischen dem Dielektrikum 10 und dem kontaktseitigen Ende 12 ist die Messspitze derart ausgebildet ist, dass die Leiter 14 der koplanaren Leiterstruktur frei im Raum und bzgl. des halternden Dielektrikums 10 federnd angeordnet sind. Der seitliche Abstand bzw. Spalt zwischen benachbarten Leitern 14 der koplanare Leiterstruktur ist dabei im Bereich ohne Dielektrikum 10 kleiner gewählt als in Bereich der Befestigung der Leitern 14 der koplanare Leiterstruktur am Dielektrikum 10, um über die gesamte Länge der koplanare Leiterstruktur eine konstante, vorbestimmte Impedanz zu erzielen. Am koaxialkabelseitigen Ende 16 der Messespitze ist am Dielektrikum 10 eine Halterung 22 für einen Manipulator (nicht dargestellt) angeordnet.

Erfindungsgemäß ist am Dielektrikum 10 eine elektronische Schaltung 24 vorgesehen. Diese elektronische Schaltung 24 ist mit einigen oder allen Leitern 14 der koplanare Leitungsstruktur und mit einigen oder allen Koaxialkabelanschlüssen 18 bzw. Gleichstromkontakten 20 elektrisch verbunden. Auf diese Weise werden von den Leitern 14 der koplanare Leiterstruktur aufgenommene Signale über die elektronische Schaltung 24 zu den Koaxialkabelanschlüssen 18 bzw. den Gleichstromkontakten 20 weitergeleitet. Umgekehrt werden ggf. Signale von den Gleichstromkontakten 20 oder den Koaxialkabelanschlüssen 18 zu den Leitern 14 der koplanare Leiterstruktur übertragen. Zum Verbinden der Leitern 14 der koplanare Leiterstruktur bzw. der Koaxialkabelanschlüsse 18 sowie der Gleichstromkontakte 20 mit der elektronischen Schaltung 24 sind auf dem Dielektrikum 10 entsprechende Leiterbahnen 26 ausgebildet.

Optional sind einzelne koplanare Leiter 14 bzw. Leitungen über die gesamte Länge des Dielektrikums 10 an der elektronischen Schaltung 24 vorbei und ohne mit dieser elektrisch verbunden zu sein bis zum koaxialkabelseitigen Ende 16 der Messespitze geführt und direkt elektrisch mit einem Koaxialkabelanschluss 18 oder einem Gleichstromkontakt 20 verbunden.

Die koplanare Leiterstruktur ist bevorzugte derart ausgebildet, dass deren Impedanz bzw. Wellenwiderstand demjenigen entspricht, den die weiterführenden Leitungen der gemessenen Schaltung bzw. der Koaxialkabel haben. Für Sonderzwecke kann jedoch die Impedanz der koplanaren Leiterstruktur auch unterschiedlich zur Impedanz der Koaxialkabel bzw. der weiterführenden Leitungen der gemessenen Schaltung sein.

Somit ist das Dielektrikum 10, welches beispielsweise als Leiterplatte oder Substrat ausgebildet ist, selbst zur Weiterführung von Signalen ausgebildet. Das Dielektrikum 10 kann freitragend ausgeführt sein und benötigen nicht zwingend eine Abschirmung.

Die elektrische Verbindung zwischen den Leitern 14 der koplanare Leiterstruktur und den jeweiligen Leiterbahnen 26 ist beispielsweise mittels Löten oder Punktschweißen hergestellt.

## Patentansprüche

1. Kontaktanordnung, insbesondere für eine Messsonde oder einen Messkopf, zur Hochfrequenzmessung, insbesondere auf einem Halbleiterwafer, mit einem kontaktseitigen Ende (12) zum elektrischen Kontaktieren von planaren Strukturen, wobei am kontaktseitigen Ende (12) eine koplanare Leiterstruktur mit wenigstens zwei von einem Dielektrikum (10) getragenen Leitern (14) angeordnet ist, wobei zwischen dem Dielektrikum (10) und dem kontaktseitigen Ende (12) die Messspitze derart ausgebildet ist, dass die Leiter (14) der koplanaren Leiterstruktur frei im Raum und bzgl. des halternden Dielektrikums (10) federnd angeordnet sind,
**dadurch gekennzeichnet,**
**dass** auf dem Dielektrikum (10) wenigstens eine Anordnung (24) zum Übertragen von elektrischen Signalen angeordnet ist, die elektrisch mit wenigstens einem Leiter (14) der koplanaren Leiterstruktur derart verbunden ist, dass diese Anordnung (24) Signale von dem wenigstens einen mit der Anordnung (24) elektrisch verbundenen Leiter (14) überträgt, wobei die Kontaktanordnung ein koaxialkabelseitiges Ende (16) mit einer koaxialen Leiterstruktur (18) aufweist, wobei die Anordnung (24) zum Übertragen von elektrischen Signalen mit wenigstens einem Koaxialkabelanschluss (18) der koaxialen Leiterstruktur derart verbunden ist, dass die Anordnung (24) Signale zwischen dem wenigstens einen mit der Anordnung (24) elektrisch verbundenen Leiter (14) und dem wenigstens einen mit der Anordnung (24) elektrisch verbundenen Koaxialkabelanschluss (18) der koaxialen Leiterstruktur überträgt, wobei sich das Dielektrikum (10) bis zum koaxialkabelseitigen Ende (16) erstreckt.

2. Kontaktanordnung nach Anspruch 1, **dadurch gekennzeichnet, dass** auf dem Dielektrikum (10) wenigstens ein Kontakt (18, 20) zum Abgreifen des elektrischen Signals angeordnet ist, wobei die Anordnung (24) zum Übertragen von elektrischen Signalen derart angeordnet und ausgebildet ist, dass die Anordnung (24) das elektrische Signal von dem wenigstens einen mit der Anordnung (24) elektrisch verbundenen Leiter (14) zum Kontakt überträgt.

3. Kontaktanordnung nach wenigstens einem der vorhergehenden Ansprüche, **dadurch gekennzeichnet, dass** die Anordnung (24) zum Übertragen von elektrischen Signalen eine elektronische Schaltung ist.

4. Kontaktanordnung nach wenigstens einem der vorhergehenden Ansprüche, **dadurch gekennzeichnet, dass** am koaxialkabelseitigen Ende (16) zwei oder mehr Koaxialkabelanschlüsse (18) zum Verbinden mit einem jeweiligen Koaxialkabel angeordnet und mit der Anordnung (24) elektrisch verbunden sind.

5. Kontaktanordnung nach wenigstens einem der vorhergehenden Ansprüche, **dadurch gekennzeichnet, dass** die Anordnung (24) zum Übertragen von elektrischen Signalen eine Umverdrahtung, ein Anpassnetzwerk und/oder eine aktive Schaltung umfasst.

6. Kontaktanordnung nach wenigstens einem der vorhergehenden Ansprüche, **dadurch gekennzeichnet, dass** am Dielektrikum (10) wenigstens ein Gleichstromkontakt (20) vorgesehen und mit der Anordnung (24) zum Übertragen von elektrischen Signalen elektrisch verbunden ist.

7. Kontaktanordnung nach wenigstens einem der vorhergehenden Ansprüche, **dadurch gekennzeichnet, dass** am Dielektrikum (10) eine Halterung (92) für einen Manipulator angeordnet ist.

8. Kontaktanordnung nach wenigstens einem der vorhergehenden Ansprüche, **dadurch gekennzeichnet, dass** die Leiter (14) der koplanaren Leiterstruktur über Löt- und/oder Punktschweißverbindungen mit jeweiligen Leiterbahnen (26) der Anordnung (24) zum Übertragen von elektrischen Signalen elektrisch verbunden sind.

9. Kontaktanordnung nach wenigstens einem der vorhergehenden Ansprüche, **dadurch gekennzeichnet, dass** zwischen je zwei Leitern (14) der koplanaren Leiterstruktur über deren gesamte Länge ein jeweiliger Spalt derart ausgebildet ist, dass sich über die Länge der koplanaren Leitungsstruktur ein konstanter Wellenwiderstand ergibt.

10. Kontaktanordnung nach Anspruch 9, **dadurch gekennzeichnet, dass** der jeweilige Spalt im Bereich des Dielektrikums (10) breiter ausgebildet ist als im Bereich der koplanaren Leiterstruktur ohne Dielektrikum.

11. Kontaktanordnung nach wenigstens einem der vorhergehenden Ansprüche, **dadurch gekennzeichnet, dass** das Dielektrikum (10) an einer der koplanaren Leiterstruktur abgewandten Seite vollflächig metallisiert ist.

12. Kontaktanordnung nach wenigstens einem der vorhergehenden Ansprüche, **dadurch gekennzeichnet, dass** das Dielektrikum (10) wenigstens einseitig, insbesondere beidseitig an der koplanaren Leiterstruktur angeordnet ist.

## Claims

1. Contact arrangement, in particular for a measuring probe or measuring head, for high-frequency measurement, in particular on a semiconductor wafer, with a contact end (12) for electrically contacting planar structures, where at the contact end (12) there is arranged a coplanar conductor structure with at least two conductors (14) carried by a dielectric (10), where between the dielectric (10) and the contact end (12) the measuring tip is configured in such a way that the conductors (14) of the coplanar conductor structure are disposed so as to be free in space and resilient relative to the retaining dielectric (10), **characterised in that** on the dielectric (10) there is arranged at least one arrangement (24) for transmitting electric signals, which is connected electrically to at least one conductor (14) of the coplanar conductor structure in such a way that this arrangement (24) transmits signals from the at least one conductor (14) that is electrically connected to the arrangement (24), where the contact arrangement exhibits a coaxial cable end (16) with a coaxial conductor structure (18), where the arrangement (24) for transmitting electrical signals is connected to at least one coaxial cable termination (18) of the coaxial conductor structure in such a way that the arrangement (24) transmits signals between the at least one conductor (14) that is electrically connected to the arrangement (24) and the at least one coaxial cable termination (18) of the coaxial conductor structure that is electrically connected to the arrangement (24), and where the dielectric (10) extends up to the coaxial cable end (16).

2. Contact arrangement according to claim 1, **characterised in that** on the dielectric (10) there is arranged at least one contact (18,20) for picking up the electric signal, where the arrangement (24) for transmitting electric signals is arranged and configured in such a way that the arrangement (24) transmits the electric signal from the at least one conductor (14) that is electrically connected with the arrangement (24) to the contact.

3. Contact arrangement according to at least one of the preceding claims, **characterised in that** the arrangement (24) for transmitting electric signals is an electronic circuit.

4. Contact arrangement according to at least one of the preceding claims, **characterised in that** at the coaxial cable end (16) there are arranged two or more coaxial cable terminations (18) for connecting to a respective coaxial cable that are electrically connected to the arrangement (24).

5. Contact arrangement according to at least one of the preceding claims, **characterised in that** the arrangement (24) for transmitting electric signals comprises a rewiring, an adaptive network and/or an active circuit.

6. Contact arrangement according to at least one of the preceding claims, **characterised in that** at the dielectric (10) there is provided at least one direct current contact (20) that is electrically connected to the arrangement (24) for transmitting electric signals.

7. Contact arrangement according to at least one of the preceding claims, **characterised in that** at the dielectric (10) there is arranged an attachment (92) for a manipulator.

8. Contact arrangement according to at least one of the preceding claims, **characterised in that** the conductors (14) of the coplanar conductor structure are electrically connected via soldered and/or point-welded connections to the respective conductor channels (26) of the arrangement (24) for transmitting electric signals.

9. Contact arrangement according to at least one of the preceding claims, **characterised in that** between any two conductors (14) of the coplanar conductor structure over its entire length a respective slot is configured in such a way as to result in a constant wave resistance over the length of the coplanar conductor structure.

10. Contact arrangement according to claim 9, **characterised in that** the respective slot is configured to be wider in the region of the dielectric (10) than **in that** region of the coplanar conductor structure where there is no dielectric.

11. Contact arrangement according to at least one of the preceding claims, **characterised in that** the dielectric (10) is metallised over its full area on a side remote from the coplanar conductor structure.

12. Contact arrangement according to at least one of the preceding claims, **characterised in that** the dielectric (10) is arranged on at least one side, and in particular on both sides, of the coplanar conductor structure.

## Revendications

1. Agencement de contact, en particulier pour une sonde de mesure ou pour une tête de mesure, pour la mesure à haute fréquence, en particulier sur une plaquette semiconductrice, comprenant une extrémité côté contact (12) destinée à venir en contact électrique avec des structures planaires, dans lequel une structure conductrice coplanaire avec au moins deux conducteurs (14) portés par un diélectrique (10) est agencée à l'extrémité côté contact (12) et, entre le diélectrique (10) et l'extrémité côté contact (12), la pointe de mesure est réalisée de telle façon que les conducteurs (14) de la structure conductrice coplanaire sont libres dans l'espace et sont agencés avec effet élastique par rapport au diélectrique (10) qui les porte,
**caractérisé en ce que**
sur le diélectrique (10) est agencé au moins un agencement (24) pour la transmission de signaux électriques, ledit agencement étant connecté électriquement avec au moins un conducteur (14) de la structure conductrice coplanaire, **en ce que** cet agencement (24) transmet des signaux depuis ledit au moins un conducteur (14) connecté électriquement à l'agencement (24), dans lequel l'agencement de contact comprend une extrémité (16) côté câble coaxial, avec une structure conductrice coaxiale (18), telle que l'agencement (24), pour la transmission de signaux électriques, est relié à au moins une borne de câble coaxial (18) de la structure conductrice coaxiale, de telle façon que l'agencement (24) transmet des signaux entre ledit au moins un conducteur (14) connecté électriquement à l'agencement (24) et ladite borne de câble coaxial (18), de la structure conductrice coaxiale, connectée électriquement à l'agencement (24), et le diélectrique (10) s'étend jusqu'à l'extrémité (16) côté câble coaxial.

2. Agencement de contact selon la revendication 1, **caractérisé en ce qu'**au moins un contact (18, 20) destiné au prélèvement du signal électrique est agencé sur le diélectrique (10), et l'agencement (24) destiné à la transmission de signaux électriques est agencé et réalisé de telle façon que l'agencement (24) transmet le signal électrique depuis ledit au moins un conducteur (14), connectée électriquement à l'agencement (24), vers le contact.

3. Agencement de contact selon l'une au moins des revendications précédentes, **caractérisé en ce que** l'agencement (24) destiné à la transmission de signaux électriques est un circuit électronique.

4. Agencement de contact selon l'une au moins des revendications précédentes, **caractérisé en ce que** deux ou plusieurs bornes de câble coaxial (18) pour la connexion avec un câble coaxial respectif sont agencées à l'extrémité (16) côté câble coaxial, et sont reliées électriquement à l'agencement (24).

5. Agencement de contact selon l'une au moins des revendications précédentes, **caractérisé en ce que** l'agencement (24) destiné à la transmission de signaux électriques comprend un câblage de conversion, un réseau d'adaptation et/ou un circuit actif.

6. Agencement de contact selon l'une au moins des revendications précédentes, **caractérisé en ce qu'**au moins un contact à courant continu (20) est prévu sur le diélectrique (10) et est connecté électriquement à l'agencement (24) pour la transmission de signaux électriques.

7. Agencement de contact selon l'une au moins des revendications précédentes, **caractérisé en ce qu'**une monture (92) pour un manipulateur est agencée sur le diélectrique (10).

8. Agencement de contact selon l'une au moins des revendications précédentes, **caractérisé en ce que** les conducteurs (14) de la structure conductrice coplanaire sont connectés électriquement à des pistes conductrices respectives (26) de l'agencement (24) pour la transmission de signaux électriques, via des connexions brasées et/ou des connexions soudées par points.

9. Agencement de contact selon l'une au moins des revendications précédentes, **caractérisé en ce qu'**une fente respective est réalisée entre deux conducteurs (14) respectifs de la structure conductrice coplanaire sur la totalité de leur longueur, de telle façon qu'il en résulte une impédance caractéristique constante sur la longueur de la structure conductrice coplanaire.

10. Agencement de contact selon la revendication 9, **caractérisé en ce que** la fente respective est réalisée plus large dans la région du diélectrique (10) que dans la région de la structure conductrice coplanaire sans diélectrique

11. Agencement de contact selon l'une au moins des revendications précédentes, **caractérisé en ce que** le diélectrique (10) est métallisé sur toute la surface sur un côté détourné de la structure conductrice coplanaire.

12. Agencement de contact selon l'une au moins des revendications précédentes, **caractérisé en ce que** le diélectrique (10) est agencé sur au moins un côté, en particulier sur les deux côtés, sur la structure conductrice coplanaire.
